# EUROPEAN PATENT SPECIFICATION

(11) **EP 4 258 317 B1**
(45) Date of publication and mention of the grant of the patent: **26.11.2025**
(21) Application number: 23305502.9
(22) Date of filing: 06.04.2023
(51) Int. Cl.: H01H 47/00, H02J 9/06, G01R 31/327, H02H 3/04

(54) **RELAY MONITORING DEVICE, DUAL POWER SUPPLY SWITCHING CONTROL DEVICE AND RELAY MONITORING METHOD**
RELAISÜBERWACHUNGSVORRICHTUNG, SCHALTSTEUERUNGSVORRICHTUNG FÜR DUALE STROMVERSORGUNG UND RELAISÜBERWACHUNGSVERFAHREN
DISPOSITIF DE SURVEILLANCE DE RELAIS, DISPOSITIF DE COMMANDE DE COMMUTATION D'ALIMENTATION ÉLECTRIQUE DOUBLE ET PROCÉDÉ DE SURVEILLANCE DE RELAIS

(30) Priority: 08.04.2022 CN 202210368320
(43) Date of publication of application: 11.10.2023
(73) Proprietor: SCHNEIDER ELECTRIC INDUSTRIES SAS, 92500 Rueil-Malmaison (FR)
(72) Inventor: HUANG, Jie, Shanghai, 201203 (CN); BI, Baoyun, Shanghai, 201203 (CN); ZHAO, Chaomin, Shanghai, 201203 (CN)
(74) Representative: Manitz Finsterwald Patent- und Rechtsanwaltspartnerschaft mbB

(56) References cited:
- EP-A2- 2 325 974
- EP-A2- 3 699 013
- US-A1- 2017 373 527

## Description

### TECHNICAL FIELD

The invention relates to relay monitoring, in particular to a relay monitoring device, a dual power supply switching control device, and a relay monitoring method.

### BACKGROUND

Relay is a switching element with an isolation function, which is widely used in product design. In order to switch the dual power supply of the main line, for example, automatic transfer switching equipment (ATSE) using relays can be utilized. ATSE switches the connection to the dual power supply through relays and uses electromagnets to control the electronic switching in the main line, thus switching the dual power supply of the main line. The scheme using ATSE is more secure than the scheme directly using switches or relays to switch power supplies in the main line. However, the relays in ATSE have a risk of contact fusion welding in the long-term application process.

The existing ATSE does not have the function of monitoring and controlling the contact fusion welding of relays. Only when the product is found to be abnormal and repaired can it be determined that the contacts of a relay are fusion welded. In addition, if the user still operates to switch the current power supply to another power supply after the fusion welding occurs in the relay(s), the two power supplies will be directly short-circuited, which causes the front-end power supply terminal to trip, making all the lower-end devices stop working, thus causing huge economic losses. In addition, the short circuit also poses a danger to the personal safety of users. US 2017/373527 A1 provides an automatic transfer switch.

### SUMMARY

As set out in the appended claims, the present invention provides a relay monitoring device for a dual power supply switching control device, comprising: a relay fusion welding monitoring unit for monitoring whether the contacts of the two relays in a power supply conversion unit in the dual power supply switching control device are fusion welded, and the two relays are respectively used for connecting one power supply of the dual power supply; a control unit for controlling the power supply conversion unit to connect to one power supply of the dual power supply to a switching execution unit in the dual power supply switching control device through the corresponding relay, and controlling the switching execution unit to connect the one power supply to a main line; and an alarm unit for alarming a user in the case that the contacts of at least one relay are fusion welded, wherein the control unit controls the power supply conversion unit not to connect any power supply of the dual power supply and controls the switching execution unit not to execute the power supply switching of the main line in the case that the contacts of at least one relay are fusion welded.

The relay fusion welding monitoring unit is connected to the common connection terminal of the two relays, and whether the contacts of the relays are fusion welded is monitored by detecting whether the voltage at the common connection terminal exceeds a threshold value in the case that any of the two relays is not controlled conductive by the control unit.

Optionally, the relay fusion welding monitoring unit comprises a current limiting and rectifying unit and a voltage detecting and comparing unit; the current limiting and rectifying unit current-limits and rectifies the voltage at the common connection terminal of the two relays; and the voltage detecting and comparing unit detects the current-limited and rectified voltage and outputs a signal indicating the existence of fusion welding in response to the detected voltage exceeding a threshold value.

Optionally, the voltage detecting and comparing unit comprises a Zener diode, a first resistor, a second resistor, a third resistor, a semiconductor electronic switching tube and an optocoupler device; the cathode of the Zener diode is connected to the positive output end of the current-limiting and rectifying unit, the anode of the Zener diode is connected to the first end of the first resistor, the second end of the first resistor is connected to the first end of the second resistor, the second end of the second resistor is connected to the negative output end of the current-limiting and rectifying unit, and the control end of the semiconductor electronic switching tube is connected to the first end of the second resistor, the first end of the semiconductor electronic switching tube is connected to the negative output end of the current-limiting and rectifying unit, the second end of the semiconductor electronic switching tube is connected to the first end of the input side of the optocoupler device, the second end of the input side of the optocoupler device is connected to the positive output end of the current-limiting and rectifying unit, the first end of the output side of the optocoupler device is used as a monitoring signal output end and connected to a reference power supply through the third resistor, and the second end of the output side of the optocoupler device is grounded.

Optionally, the control unit determines that fusion welding occurs in two relays in the case that the main line trips, and determines that the fusion welding occurs in one relay in the case that the main line does not trip and the fusion welding is monitored by the relay fusion welding monitoring unit.

Optionally, the control unit determines the relay that is finally controlled to be turned off before the fusion welding is monitored as the relay in which the fusion welding occurs, in the case that the main line does not trip and the fusion welding is monitored by the relay fusion welding monitoring unit.

Optionally, in the case that the fusion welding is monitored by the relay fusion welding monitoring unit, the control unit controls the relay in which the fusion welding occurs to be continuously turned on and off until the fusion welding is no longer monitored or the turning on and off have been executed for a predetermined number of times.

Optionally, the alarm unit alarms in different manners for different relays in which the fusion welding occurs.

Optionally, the alarm unit alarms in different manners for the situation where the fusion welding occurs in one relay and the situation where the fusion welded occurs in two relays.

According to another aspect of the embodiment of the present disclosure, a dual power supply switching control device is provided, comprising the above described relay monitoring device; a switching execution unit for executing power supply switching of the main line under the control of a control unit of the relay monitoring device; and a power supply conversion unit for connecting the switching execution unit to one power supply of the dual power supply under the control of the control unit of the relay monitoring device.

According to another aspect of the embodiment of the present disclosure, a relay monitoring method for the dual power supply switching control device is provided, comprising: monitoring whether the contacts of two relays in a power supply conversion unit in the dual power supply switching control device are fusion welded, wherein the two relays are respectively used for connecting one power supply of the dual power supply; and in the case that the contacts of at least one relay are fusion welded, alarming to the user and controlling the power supply conversion unit not to connect any power supply of the dual power supply and controlling a switching execution unit in the dual power supply switching control device not to execute the power supply switching of a main line.

According to the embodiment of the present disclosure, the fusion welding of the contacts of the relay(s) of the dual-power supply switching control device can be monitored in time, and when the fusion welding is monitored, the power supply conversion unit is controlled not to connect to any power supply of the dual-power supply and the switching execution unit is controlled not to execute the power supply switching of the main line. Thus, the subsequent risks caused by fusion welding are automatically eliminated, serious accidents such as personal safety and economic loss caused by switching failure or forced switching are avoided, product safety and equipment safety at the load end of the main line are ensured, and the operation of dual-power supply products is made safer. In addition, the user is alarmed to when the fusion welding is detected, so that the user can quickly recognize the fusion welding of the contacts of the relay(s) and maintain or replace the product. In addition, the implementation method is simple and the cost is low.

### BRIEF DESCRIPTION OF DRAWINGS

These and/or other aspects, features and advantages of the present disclosure will become clearer and easier to understand from the following description of the embodiments taken in conjunction with the accompanying drawings, in which:
Fig. 1 is a schematic diagram showing a dual power supply circuit system according to an embodiment of the present disclosure.
Fig. 2 is an example circuit diagram of a relay fusion welding monitoring unit according to an embodiment of the present disclosure.
Fig. 3 is a flowchart of a relay control method according to an embodiment of the present disclosure.
Fig. 4 is a flowchart of an example of relay fusion welding monitoring steps of a relay control method according to an embodiment of the present disclosure.

### DETAILED DESCRIPTION

The present disclosure will be described in detail below with reference to exemplary embodiments thereof. However, the present disclosure is not limited to the embodiments described herein, and it can be implemented in many different forms. The described embodiments are only used to make this disclosure thorough and complete, and fully convey the concept of this disclosure to those skilled in the art. Features of the described embodiments may be combined or substituted with each other unless explicitly excluded or should be excluded according to the context.

There is a risk of contact fusion welding in the long-term application of a relay, but the existing ATSE does not have the function of monitoring and controlling the contact fusion welding of a relay. For example, in order to switch from one power supply to another, it is necessary to switch one relay from on to off and the other relay from off to on. However, if the fusion welding occurs in one relay that should be completely turned off and therefore the relay cannot be completely turned off, turning on the other relay will cause two power supplies to be directly short-circuited, causing the front-end power supply terminal to trip, making all the lower-end devices stop working, thus causing huge economic losses, and the short-circuit will also pose a danger to the personal safety of users.

In view of the above problems of the existing ATSE, an embodiment of the present disclosure proposes a relay monitoring device for a dual power supply switching control device, comprising: a relay fusion welding monitoring unit for monitoring whether the contacts of two relays in a power supply conversion unit in the dual power supply switching control device are fusion welded, and the two relays are respectively used for connecting one power supply of the dual power supply; a control unit for controlling the power supply conversion unit to connect one power supply of the dual power supply to the switching execution unit in the dual power supply switching control device through the corresponding relay, and controlling the switching execution unit to connect the one power supply to the main line; and an alarm unit for alarming to a user in the case that the contacts of at least one relay are fusion welded, wherein the control unit controls the power supply conversion unit not to connect any power supply of the dual power supply and controls the switching execution unit not to execute power supply switching of the main line in the case that the contacts of at least one relay are fusion welded.

In addition, the embodiment of the present disclosure provides a dual power supply switching control device, comprising: the above described relay monitoring device; a switching execution unit for executing power supply switching of the main line under the control of the control unit of the relay monitoring device; and a power supply conversion unit for connecting the switching execution unit to one power supply of the dual power supply under the control of the control unit of the relay monitoring device.

In addition, the embodiment of the present disclosure provides a relay monitoring method for a dual power supply switching control device, comprising: monitoring whether the contacts of two relays in a power supply conversion unit in the dual power supply switching control device are fusion welded, and the two relays are respectively used for connecting one power supply of the dual power supply; and in the case that the contacts of at least one relay are fusion welded, alarming to the user, and controlling the power supply conversion unit not to connect any power supply of the dual power supply and controlling the switching execution unit in the dual power supply switching control device not to execute the power supply switching of the main line.

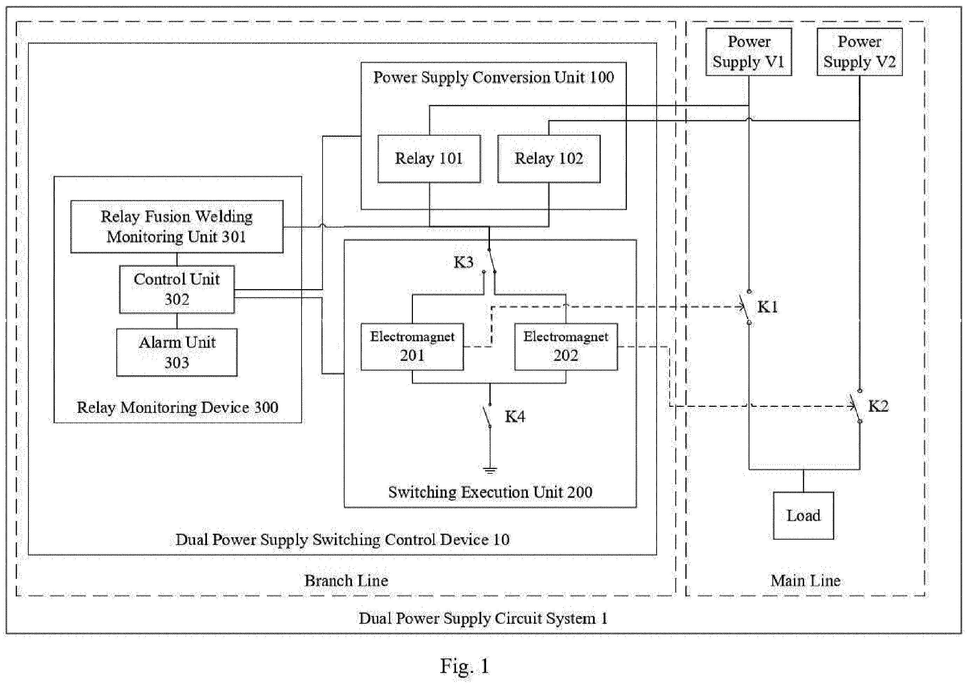

Fig. 1 is a schematic diagram showing a dual power supply circuit system 1 according to an embodiment of the present disclosure, which may include a dual power supply switching control device 10 and a relay monitoring device 300 thereof proposed by the embodiment of the present disclosure.

In Fig.1, a dual power supply circuit system 1 may include dual power supply V1 and V2, two switches K1 and K2 corresponding to the power supplies V1 and V2, a load, and a dual power supply switching control device 10, wherein the dual power supply V1 and V2, the two switches K1 and K2, and the load construct a main line, and the dual power supply switching control device 10 constructs a branch line. The dual power supply switching control device 10 is used to implement the switching of two power supplies V1 and V2 in the main line. Specifically, the two switches K1 and K2 are respectively controlled to be turned on/off by electromagnets 201 and 202 in the dual power supply switching control device 10.

The dual power supply switching control device 10 may include a power supply conversion unit 100, a switching execution unit 200, and a relay monitoring device 300.

The power supply conversion unit 100 is used to connect the switching execution unit 200 to one power supply of the dual power supply V1 and V2 under the control of the control unit 302 of the relay monitoring device 300. The power supply conversion unit 100 includes relay 101 and relay 102, which are respectively used for connecting one power supply of the dual power supply. For example, in order to select the power supply V1, the relay 101 is controlled to be turned on and the relay 102 is controlled to be turned off. On the contrary, in order to select the power supply V2, the relay 102 is controlled to be turned on and the relay 101 is controlled to be turned off. When the power supply is a multi-phase power supply, the relays 101 and 102 can also be relay groups respectively. For example, when the power supply is a three-phase alternating current power supply, each of relays 101 and 102 can be a relay group composed of relays corresponding to each phase respectively. In addition, the power supply conversion unit 100 may optionally include other relays downstream of the relays 101 and 102 for more reliably selecting one of the two power supplies to connect to. For example, a relay for selecting one of the branch of the relay 101 and the branch of the relay 102, for example, a single-pole double-throw switching relay, can also be connected downstream of the relays 101 and 102, so as to further ensure the mutually exclusive connection of the two power supplies.

The switching execution unit 200 is used to execute power supply switching of the main line under the control of the control unit 302 of the relay monitoring device 300. The switching execution unit 200 includes, for example, an electromagnet 201 and an electromagnet 202 (e.g., solenoid electromagnet), which respectively control two switches K1 and K2 in the main line, thereby controlling power supply switching in the main line. For example, the switching execution unit 200 may include a switch K3 for connecting power supply from the power supply conversion unit 100 to one of the electromagnets 201 or 202, and the switch K3 may be, for example, a single-pole double-throw relay. The switching execution unit 200 may further include a switch K4 for setting up the switching execution unit 200, which may be, for example, a semiconductor electronic switch, such as IGBT, MOSFET, etc. The switching execution unit 200 may further include a signal isolation device for transmitting the control signal from the control unit 302 to the switch K4 and isolating the power supply of the control unit 302 and the switching execution unit 200.

The relay monitoring device 300 may include a relay fusion welding monitoring unit 301, a control unit 302, and an alarm unit 303.

The relay fusion welding monitoring unit 301 is used to monitor whether the contacts of two relays 101 and 102 in the power supply conversion unit 100 in the dual power supply switching control device 10 are fusion welded, and the two relays 101 and 102 are used to connect one power supply of the dual power supply V1 and V2 respectively. For example, fusion welding monitoring may be performed in the following ways: the relay fusion welding monitoring unit 301 is connected to the common connection terminal of two relays 101 and 102 (for example, the lower connection point of two relays in Figure 1), and whether the contacts of the relays are fusion welded is monitored by detecting whether the voltage at the common connection terminal exceeds a threshold value in the case that the any of the two relays 101 and 102 is not controlled conductive by the control unit 302. In the case that fusion welding occurs in any one of the relays, even if the control unit 302 has performed an operation for turning off the relay, the voltage of the power supply is still transmitted to the relay fusion welding monitoring unit 301 because the relay is not actually turned off due to the fusion welding. Therefore, as long as the relay fusion welding monitoring unit 301 still detects high voltage (exceeding the threshold value), there is at least one relay in which fusion welding occurs. The threshold value here can be preset according to the actual power supply voltage and relay specifications.

The relay fusion welding monitoring unit 301 may include a current-limiting and rectifying unit and a voltage detecting and comparing unit. The current limiting and rectifying unit is used to current-limit and rectify the voltage at the common connection terminal of the two relays 101 and 102, so that the bidirectional AC voltage can be converted into unidirectional voltage and the current can be limited. The voltage detecting and comparing unit is used for detecting the current-limited and rectified voltage and outputting a signal indicating the existence of fusion welding in response to the detected voltage exceeding a threshold value. The voltage detecting and comparing unit may implement voltage detection and threshold value comparison by comparators, semiconductor switches and other devices.

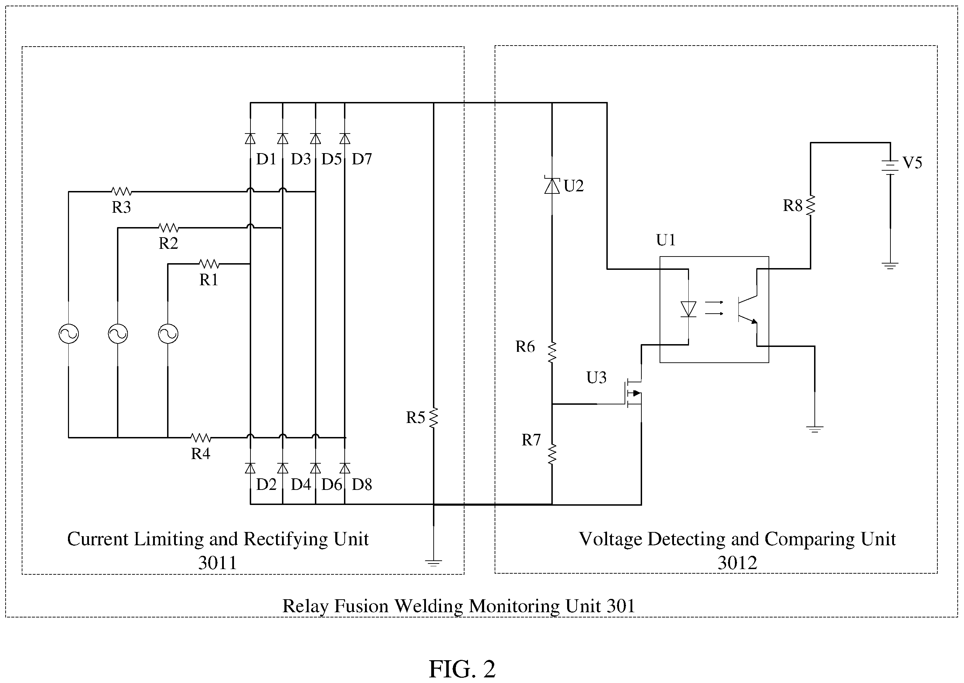

Fig. 2 is an example circuit diagram of a relay fusion welding monitoring unit 301 according to an embodiment of the present disclosure. The relay fusion welding monitoring unit 301 includes, for example, a current-limiting and rectifying unit 3011 and a voltage detecting and comparing unit 3012.

Fig. 2 is an example of relay fusion welding monitoring unit 301 in the case that the outputs of power supplies V1 and V2 are all three-phase alternating current. The relays 101 and 102 may both be relay groups, which are composed of relays configured corresponding to each phase. The common connection terminal of relays 101 and 102 corresponding to each phase is the power input terminal in Fig. 2.

The current limiting and rectifying unit 3011 current-limits and rectifies the voltage at the common connection terminal of the two relays 101 and 102. The current limiting and rectifying unit 3011 includes, for example, current limiting resistors R1 to R4, a three-phase four-wire rectifier bridge composed of D1 to D8, and an output voltage adjusting resistor R5. If the contacts are fusion welded, the contacts may still be connected even if an operation for disconnecting them has been performed, so that the voltage still exists at the common connection terminal of relays 101 and 102. In this case, the current limiting resistors R1~R4 limit the current in the working loop, and the rectifier bridge rectifies the bidirectional AC signal into a unidirectional signal. The rectified voltage is adjusted by adjusting the resistance value of the output voltage adjusting resistor R5, so that the monitored threshold value is a predetermined value, for example, 85 V. As long as the input voltage is greater than the threshold value, the post-stage circuit enters the detection state.

The voltage detecting and comparing unit 3012 detects the current-limited and rectified voltage and outputs a signal indicating the existence of fusion welding in response to the detected voltage exceeding a threshold value.

In one example, the voltage detecting and comparing unit 3012 may include a Zener diode U2, a voltage dividing circuit composed of a resistor R6 and a resistor R7, a semiconductor electronic switching tube U3, an optocoupler device U1, and a resistor R8. The cathode of the Zener diode U2 is connected to the positive output end of current limiting and rectifying unit 3011 (i.e. the upper end in Figure 2), the anode of the Zener diode U2 is connected to the first end of resistor R6, the second end of resistor R6 is connected to the first end of resistor R7, the second end of resistor R7 is connected to the negative output end of current limiting and rectifying unit 3011 (i.e. the lower end in Figure 2), and the control end of semiconductor electronic switching tube U3 is connected to the first end of R7, and the first end of the semiconductor electronic switching tube U3 is connected to the negative output end of the current limiting and rectifying unit 3011, and the second end of the semiconductor electronic switching tube U3 is connected to the first end of the input side of the optocoupler device U1, and the second end of the input side of the optocoupler device U1 is connected to the positive output end of the current limiting and rectifying unit 3011, and the first end of the output side of the optocoupler device U1 serves as the monitoring signal output end and is connected to the reference power source V5 through a resistor R8, and the second end of the output side of the optocoupler device U1 is grounded. The control terminal of the semiconductor electronic switching tube U3 can control the conduction and cut-off of its first and second terminals. The semiconductor electronic switching tube U3 can be, for example, a MOSFET tube, a triode, etc. In the example of Fig. 2, the semiconductor electronic switching tube U3 can be an NPN MOSFET tube, and its control terminal is the gate electrode, the first terminal is the drain electrode, and the second terminal is the source electrode.

Without the fusion welding, there is no voltage between the output terminals of the current limiting and rectifying unit 3011, the Zener diode U2 is not conductive, and the semiconductor electronic switching tube U3 is also not conductive, so the input terminal of the optocoupler U1 is not conductive, the output terminal of the optocoupler U1 is cut-off, and the monitoring signal output terminal is at a high level. Upon the fusion welding occurs, the rectified voltage output by the current limiting and rectifying unit 3011 is greater than the clamping voltage of the Zener diode U2, and a current is generated in the resistors R6 and R7, which leads to the voltage across the resistor R7 being greater than the conduction voltage of the semiconductor electronic switching tube U3, so that the semiconductor electronic switching tube U3 is conductive. The current is input into the input side of the optocoupler device U1, and the light-emitting diode emits light, which leads to the conduction of the output side circuit, so that the monitoring signal output terminal is grounded and becomes low level. That is, the level of the monitoring signal output terminal is reversed, so that the fusion welding of the contact of a relay is detected.

Returning to Fig.1, the control unit 302 is used to control the power supply conversion unit 100 to connect one power supply of the dual power supply V1 and V2 to the switching execution unit 200 in the dual power supply switching control device 10 through the corresponding relay, and to control the switching execution unit 200 to connect the one power supply to the main line. In the case that the contacts of at least one relay are fusion welded, the control unit 302 controls the power supply conversion unit 100 not to connect to either power supply of the dual power supply V1 and V2 and controls the switching execution unit 200 not to switch the power supply of the main line. Optionally, the control unit 302 can also determine whether the fusion welding occurs in one relay 101 or 102 or in both the two relays 101 and 102 both. For example, the control unit 302 determines that the fusion welding occurs in two relays 101 and 102 in the case that the line trips, and determines that the fusion welding occurs in one relay in the case that the line does not trip and the relay fusion welding monitoring unit 301 has monitored the fusion welding. Further, the control unit 302 can also determine which relay is the relay in which the fusion welded occurs in the case that the fusion welding occurs in one relay. For example, in the case that the line does not trip and the relay fusion welding monitoring unit 301 has monitored the fusion welding, the control unit 302 can determine the relay that was finally controlled to be off before monitoring the fusion welding as a fusion welded relay. For example, in order to switch the power supply of the main line to the power supply V1, the control unit 302 first controls the relay 101 to turn on, and then controls the relay 101 to turn off after the switching is completed. After the relay 101 is controlled to be turned off, if the relay fusion welding monitoring unit 301 monitors the relay fusion welding, and the relay that was finally controlled to be turned off before the fusion welding is monitored is the relay 101, the control unit 302 determines the relay 101 as the relay in which the fusion welding occurs. The reason for the determination is that the fusion welding short circuit generally occurs during the time period in which the relay is switched from on to off. In addition, the control unit 302 can repeatedly separate the fusion welded contacts of a particular relay in the case that the fusion welding has been monitored in the particular relay, so as to restore the particular relay to normal. For example, the control unit 302 can control the relay in which the fusion welding occurs to be continuously turned on and off in the case that the relay fusion welding monitoring unit 301 has monitored the fusion welding occurs in the relay, until the fusion welding is on longer detected or the turning on and off have been executed for a predetermined number of times. If the fusion welding is no longer monitored after controlling the relay to be turned on and off one or more times, it means that the relay is restored to normal. If the fusion welding is still detected after a predetermined number of such attempts, the attempt is then aborted. The control unit 302 can be any processing device such as a microcontroller MCU.

The alarm unit 303 is used to alarm to the user in the case that the contacts of at least one relay are fusion welded. The alarm unit 303 can give an alarm in auditory and/or visual manners. For example, the alarm unit 303 may include an LED and/or an LCD. An alarm is given by flashing the LED indicator and/or displaying a failure message by LCD to remind users to carry out maintenance or replacement.

In addition, in order to make it easier for the user to confirm the failure situation, the alarm unit 303 can also alarm to the user in different manners for different relays in which fusion welding occurs. Furthermore, in order for the user to more quickly know the situation that the fusion welding occurs in both two relays (because the consequences of this situation are more serious), the alarm unit 303 can give distinguished alarms for the situation that the fusion welding occurs in one relay and the situation that the fusion welding occurs in two relays.

The relay monitoring device 300 and the dual power supply switching control device 10 according to the embodiment of the present disclosure have been described above by taking Figs. 1 and 2 as examples. According to the embodiment of the present disclosure, the fusion welding of contacts of a relay of the dual power supply switching control device 10 can be monitored in time. **In** response to monitoring the fusion welding, the power supply conversion unit 100 is controlled not to connect any power supply of the dual power supply V1 and V2, and the switching execution unit 200 is controlled not to execute power supply switching on the main line, so that the risks caused by the fusion welding can be automatically eliminated, serious accidents such as personal safety and economic loss caused by switching failure or forced switching can be avoided, product safety and equipment safety at the load end of the main line can be ensured, and the operation of dual power supply products can be safer. **In** addition, the user is alarmed to upon the fusion welding being monitored, so that the user can quickly recognize the fusion welding of the contacts of a relay and maintain or replace the product. **In** addition, the implementation method is simple and the cost is low.

It should be noted that the relay monitoring device according to the embodiment of the present disclosure is not only applicable to the structure of the dual power supply switching control device 10 shown in Fig. 1, but also applicable to any type of dual power supply switching control device, such as the existing ATSE. The relay monitoring device according to the embodiment of the present disclosure may be a part of the dual power supply switching control device or a separate additional device.

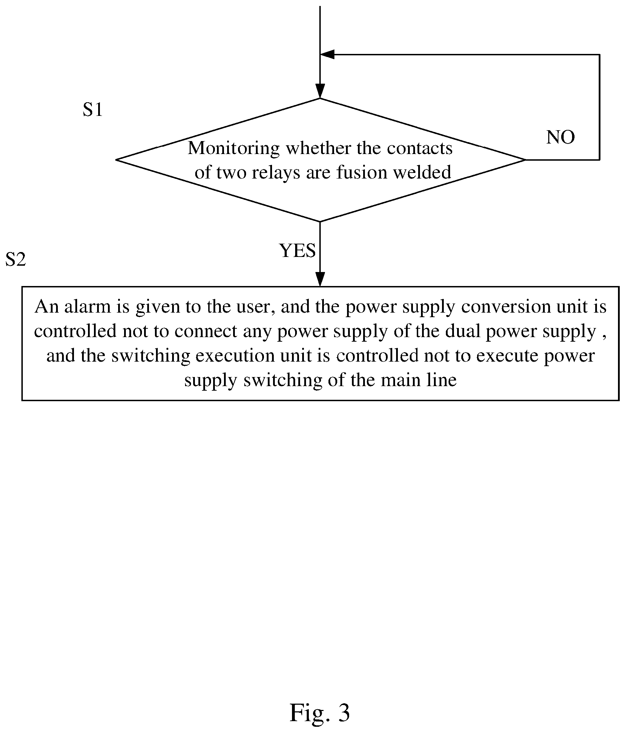

Fig. 3 is a flowchart of a relay control method according to an embodiment of the present disclosure, which can be executed by a dual power supply switching control device or a relay monitoring device. The detailed description of the dual power supply switching control device and the relay monitoring device in combination with Figure 1 and Figure 2 above is also applicable to the relay control method.

**In** step S1, it is monitored whether the contacts of the two relays 101 and 102 in the power supply conversion unit 100 in the dual power supply switching control device 10 are fusion welded. The method of monitoring fusion welding may be, for example, monitoring whether there are contacts of relay 101 and/or 102 are fusion welded by detecting whether the voltage at the common connection terminal of the two relays 101 and 102 exceeds a threshold value in the case that any of the relays 101 and 102 is not controlled conductive. If the contacts of at least one relay are fusion welded, proceed to step S2, and if the fusion welding is not monitored, return to step S1.

In step S2, an alarm is given to the user, and the power supply conversion unit 100 is controlled not to connect any power supply of the dual power supply V1 and V2, and the switching execution unit 200 is controlled not to execute power supply switching of the main line.

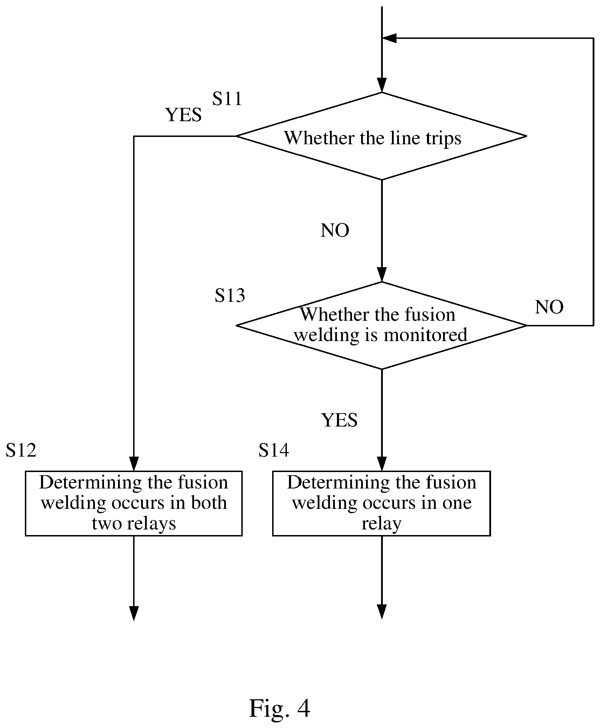

Fig. 4 is a flowchart of an example of relay fusion welding monitoring steps of a relay control method according to an embodiment of the present disclosure.

In step S11, it is determined whether the line trips, and if so, it proceeds to step S12, and if not, it proceeds to step S13.

In step S12, it is determined that the fusion welding occurs in both two relays 101 and 102 because the short-circuit due to the fusion welding in both relays 101 and 102 results in tripping.

In step S13, it is determined whether the fusion welding is monitored, and if so, the process proceeds to step S14, and if not, it can return to step S11.

In step S14, it is determined that the fusion welding occurs in one relay, and optionally, the relay that was finally controlled to be off before fusion welding is monitored may be determined as the relay in which the fusion welded occurs.

In the case that it is determined in which relay the fusion welding occurs, the relay can be controlled to continuously turn on and off to disconnect the contacts of the relay until the fusion welding is no longer monitored or the turning on and off have been executed for a predetermined number of times.

In the case that it is determined which relay is the relay in which the fusion welding occurs, the manner of alarming to the user may vary depending on which relay is the relay in which the fusion welding occurs.

In the case that it is determined which relay is the relay in which the fusion welding occurs, the manner of alarming to the user may vary depending on whether the fusion welding occurs in one or both relays.

## Claims

1. A relay monitoring device (300) for a dual power supply switching control device (10), comprising:
a relay fusion welding monitoring unit (301), for monitoring whether contacts of two relays (101,102) in a power supply conversion unit (100) in the dual power supply switching control device (10) are fusion welded, and the two relays (101,102) are respectively used for connecting one power supply of the dual power supply (V1,V2);
a control unit for controlling the power supply conversion unit (100) to connect one power supply of the dual power supply (V1,V2) to a switching execution unit (200) in the dual power supply switching control device (10) through the corresponding relay (101,102), and controlling the switching execution unit (200) to connect the one power supply to a main line; and
an alarm unit (303) for alarming to a user in the case that the contacts of at least one relay are fusion welded, wherein
the control unit (302) controls the power supply conversion unit (100) not to connect any power supply of the dual power supply (V1,V2) and controls the switching execution unit (200) not to execute power supply switching of the main line in the case that the contacts of at least one relay (101,102) are fusion welded, **characterized in that**,
the relay fusion welding monitoring unit (301) is connected to a common connection terminal of the two relays (101, 102), and whether the contacts of the relays (101, 102) are fusion welded is monitored by detecting whether the voltage at the common connection terminal exceeds a threshold value in the case that any of the two relays (101, 102) is not controlled conductive by the control unit (302).

2. The relay monitoring device (300) of claim 1, wherein,
the relay fusion welding monitoring unit (301) comprises a current limiting and rectifying unit (3011) and a voltage detecting and comparing unit (3012);
the current limiting and rectifying unit (3011) current-limits and rectifies the voltage at the common connection terminal of the two relays (101, 102); and
the voltage detecting and comparing unit (3012) detects the current-limited and rectified voltage and outputs a signal indicating the existence of fusion welding in response to the detected voltage exceeding a threshold value.

3. The relay monitoring device (300) of claim 2, wherein,
the voltage detecting and comparing unit (3012) comprises a Zener diode (U2), a first resistor (R1), a second resistor (R2), a third resistor (R3), a semiconductor electronic switching tube (U3) and an optocoupler device (U1);
the cathode of the Zener diode is connected to the positive output end of the current limiting and rectifying unit (3011), the anode of the Zener diode (U2) is connected to the first end of the first resistor (R1), the second end of the first resistor (R1), is connected to the first end of the second resistor (R2), the second end of the second resistor (R2) is connected to the negative output end of the current limiting and rectifying unit (3011), and the control end of the semiconductor electronic switching tube (U3) is connected to the first end of the second resistor (R2), the first end of the semiconductor electronic switching tube (U3) is connected to the negative output end of the current limiting and rectifying unit (3011), the second end of the semiconductor electronic switching tube (U3) is connected to the first end of the input side of the optocoupler device (U1), the second end of the input side of the optocoupler device (U1) is connected to the positive output end of the current limiting and rectifying unit (3011), the first end of the output side of the optocoupler device (U1) is used as a monitoring signal output end and connected to a reference power supply through the third resistor (R3), and the second end of the output side of the optocoupler device (U1) is grounded.

4. The relay monitoring device (300) of claim 1, wherein,
the control unit (302) determines that the fusion welding occurs in two relays (101,102), in the case that the main line trips,
the control unit (302) determines that the fusion welding occurs in one relay (101,102), in the case that the main line does not trip and the fusion welding is monitored by the relay fusion welding monitoring unit (301).

5. The relay monitoring device (300) of claim 4, wherein,
the control unit (302) determines the relay that is finally controlled to be turned off before the fusion welding is monitored as the relay in which the fusion welding occurs, in the case that the main line does not trip and the fusion welding is monitored by the relay fusion welding monitoring unit (301).

6. The relay monitoring device (300) of claim 5, wherein,
in the case that the fusion welding is monitored by the relay fusion welding monitoring unit (301), the control unit (302) controls the relay in which the fusion welding occurs to be continuously turned on and off until the fusion welding is no longer monitored or the turning on and off have been executed for a predetermined number of times.

7. The relay monitoring device (300) of claim 5, wherein,
the alarm unit (303) alarms in different manners for different relays in which the fusion welding occurs, or
the alarm unit (303) alarms in different manners for the situation where the fusion welding occurs in one relay (101,102) and the situation where the fusion welded occurs in two relays (101,102).

8. A dual power supply switching control device (10), comprising:
a relay monitoring device (300) according to any one of claims 1 to 7;
a switching execution unit (200) for executing power supply switching of the main line under the control of a control unit (302) of the relay monitoring device (300); and
a power supply conversion unit (100) for connecting the switching execution unit (200) to one power supply of the dual power supply (V1,V2) under the control of the control unit (302) of the relay monitoring device (300).

9. A relay monitoring method for a dual power supply switching control device (10) according to claim 8, comprising:
monitoring whether contacts of two relays (101, 102) in a power supply conversion unit (100) in the dual power supply switching control device (10) are fusion welded, wherein the two relays (101, 102) are respectively used for connecting one power supply of the dual power supply (V1,V2); and
in the case that the contacts of at least one relay (101,102) are fusion welded, alarming to a user and controlling the power supply conversion unit (100) not to connect any power supply of the dual power supply (V1,V2) and controlling a switching execution unit (200) in the dual power supply switching control device (10) not to execute the power supply switching of a main line.

10. The relay monitoring method of claim 9, wherein,
determining that the fusion welding occurs in two relays (101,102) in the case that the main line trips,
determining that the fusion welding occurs in one relay (101,102) in the case that the main line does not trip and the fusion welding is monitored by the fusion welding monitoring unit.

11. The relay monitoring method of claim 9, wherein,
in the case that the main line does not trip and the fusion welding is monitored, determining the relay that is finally controlled to be off before the fusion welding is monitored as the relay in which the fusion welding occurs.

12. The relay monitoring method of claim 11, wherein,
in the case that the fusion welding is monitored, controlling the relay (101,102) in which the fusion welding occurs to be continuously turned on and off until the fusion welding is no longer monitored or the turning on and off have been executed for a predetermined number of times.

13. The relay monitoring method of claim 11, wherein,
the manner of alarming to the user varies depending on which relay (101,102) is the relay in which the fusion welding occurs, or
the manners of alarming to the user varies depending on whether the fusion welding occurs in one or both relays (101,102).

## Patentansprüche

1. Relaisbeobachtungsvorrichtung (300) für eine Schaltsteuervorrichtung (10) mit zwei Stromversorgungen, umfassend:
eine Relaisschmelzschweiß-Beobachtungseinheit (301) zum Beobachten, ob Kontakte von zwei Relais (101, 102) in einer Stromversorgungs-Umwandlungseinheit (100) in der Schaltsteuervorrichtung (10) mit zwei Stromversorgungen schmelzgeschweißt sind, und die zwei Relais (101, 102) jeweils zum Verbinden einer Stromversorgung der zwei Stromversorgungen (V1, V2) verwendet werden;
eine Steuereinheit zum Steuern der Stromversorgungs-Umwandlungseinheit (100), um eine Stromversorgung der zwei Stromversorgungen (V1, V2) mit einer Schaltausführungseinheit (200) in der Schaltsteuervorrichtung (10) mit zwei Stromversorgungen durch das entsprechende Relais (101, 102) zu verbinden, und zum Steuern der Schaltausführungseinheit (200), um die eine Stromversorgung mit einer Hauptleitung zu verbinden; und
eine Alarmeinheit (303) zum Alarmieren eines Benutzers in dem Fall, dass die Kontakte von mindestens einem Relais schmelzgeschweißt sind, wobei
die Steuereinheit (302) die Stromversorgungs-Umwandlungseinheit (100) steuert, um keine Stromversorgung der zwei Stromversorgungen (V1, V2) zu verbinden, und die Schaltausführungseinheit (200) steuert, um kein Stromversorgungsschalten der Hauptleitung in dem Fall auszuführen, dass die Kontakte von mindestens einem Relais (101, 102) schmelzgeschweißt sind, **dadurch gekennzeichnet, dass**
die Relaisschmelzschweiß-Beobachtungseinheit (301) mit einem gemeinsamen Verbindungsanschluss der zwei Relais (101, 102) verbunden ist und beobachtet wird, ob die Kontakte der Relais (101, 102) schmelzgeschweißt sind, indem detektiert wird, ob die Spannung an dem gemeinsamen Verbindungsanschluss einen Schwellenwert überschreitet, in dem Fall, dass irgendeines der zwei Relais (101, 102) durch die Steuereinheit (302) nicht leitend gesteuert wird.

2. Relaisbeobachtungsvorrichtung (300) nach Anspruch 1, wobei
die Relaisschmelzschweiß-Beobachtungseinheit (301) eine Strombegrenzungs- und Gleichrichtungseinheit (3011) und eine Spannungsdetektions- und -vergleichseinheit (3012) umfasst;
die Strombegrenzungs- und Gleichrichtungseinheit (3011) die Spannung an dem gemeinsamen Verbindungsanschluss der zwei Relais (101, 102) Strom begrenzt und gleichrichtet; und
die Spannungsdetektions- und -vergleichseinheit (3012) die strombegrenzte und gleichgerichtete Spannung detektiert und ein Signal ausgibt, das das Vorhandensein von Schmelzschweißen als Reaktion darauf anzeigt, dass die detektierte Spannung einen Schwellenwert überschreitet.

3. Relaisbeobachtungsvorrichtung (300) nach Anspruch 2, wobei
die Spannungsdetektions- und -vergleichseinheit (3012) eine Zenerdiode (U2), einen ersten Widerstand (R1), einen zweiten Widerstand (R2), einen dritten Widerstand (R3), eine elektronische Halbleiterschaltröhre (U3) und eine Optokopplervorrichtung (U1) umfasst;
die Kathode der Zenerdiode mit dem positiven Ausgangsende der Strombegrenzungs- und Gleichrichtungseinheit (3011) verbunden ist, die Anode der Zenerdiode (U2) mit dem ersten Ende des ersten Widerstands (R1) verbunden ist, das zweite Ende des ersten Widerstands (R1) mit dem ersten Ende des zweiten Widerstands (R2) verbunden ist, das zweite Ende des zweiten Widerstands (R2) mit dem negativen Ausgangsende der Strombegrenzungs- und Gleichrichtungseinheit (3011) verbunden ist und das Steuerende der elektronischen Halbleiterschaltröhre (U3) mit dem ersten Ende des zweiten Widerstands (R2) verbunden ist, das erste Ende der elektronischen Halbleiterschaltröhre (U3) mit dem negativen Ausgangsende der Strombegrenzungs- und Gleichrichtungseinheit (3011) verbunden ist, das zweite Ende der elektronischen Halbleiterschaltröhre (U3) mit dem ersten Ende der Eingangsseite der Optokopplervorrichtung (U1) verbunden ist, das zweite Ende der Eingangsseite der Optokopplervorrichtung (U1) mit dem positiven Ausgangsende der Strombegrenzungs- und Gleichrichtungseinheit (3011) verbunden ist, das erste Ende der Ausgangsseite der Optokopplervorrichtung (U1) als ein Beobachtungssignalausgangsende verwendet wird und durch den dritten Widerstand (R3) mit einer Referenzstromversorgung verbunden ist und das zweite Ende der Ausgangsseite der Optokopplervorrichtung (U1) geerdet ist.

4. Relaisbeobachtungsvorrichtung (300) nach Anspruch 1, wobei
die Steuereinheit (302) bestimmt, dass das Schmelzschweißen in zwei Relais (101, 102) erfolgt, in dem Fall, dass die Hauptleitung auslöst,
die Steuereinheit (302) bestimmt, dass das Schmelzschweißen in einem Relais (101, 102) erfolgt, in dem Fall, dass die Hauptleitung nicht auslöst und das Schmelzschweißen durch die Relaisschmelzschweiß-Beobachtungseinheit (301) beobachtet wird.

5. Relaisbeobachtungsvorrichtung (300) nach Anspruch 4, wobei die Steuereinheit (302) bestimmt, dass das Relais, das schließlich gesteuert wird, um ausgeschaltet zu werden, bevor das Schmelzschweißen beobachtet wird, das Relais ist, in dem das Schmelzschweißen erfolgt, in dem Fall, dass die Hauptleitung nicht auslöst und das Schmelzschweißen durch die Relaisschmelzschweiß-Beobachtungseinheit (301) beobachtet wird.

6. Relaisbeobachtungsvorrichtung (300) nach Anspruch 5, wobei
in dem Fall, dass das Schmelzschweißen durch die Relaisschmelzschweiß-Beobachtungseinheit (301) beobachtet wird, die Steuereinheit (302) das Relais, in dem das Schmelzschweißen erfolgt, so steuert, dass es kontinuierlich ein- und ausgeschaltet wird, bis das Schmelzschweißen nicht mehr beobachtet wird oder das Ein- und Ausschalten für eine vorbestimmte Anzahl von Malen ausgeführt wurde.

7. Relaisbeobachtungsvorrichtung (300) nach Anspruch 5, wobei
die Alarmeinheit (303) auf unterschiedliche Weisen für unterschiedliche Relais alarmiert, in denen das Schmelzschweißen erfolgt, oder
die Alarmeinheit (303) auf unterschiedliche Weisen für die Situation alarmiert, in der das Schmelzschweißen in einem Relais (101, 102) erfolgt, und die Situation alarmiert, in der das Schmelzschweißen in zwei Relais (101, 102) erfolgt.

8. Schaltsteuervorrichtung (10) mit zwei Stromversorgungen, umfassend:
eine Relaisbeobachtungsvorrichtung (300) nach einem der Ansprüche 1 bis 7;
eine Schaltausführungseinheit (200) zum Ausführen eines Stromversorgungsschaltens der Hauptleitung unter der Steuerung einer Steuereinheit (302) der Relaisbeobachtungsvorrichtung (300); und
eine Stromversorgungs-Umwandlungseinheit (100) zum Verbinden der Schaltausführungseinheit (200) mit einer Stromversorgung der zwei Stromversorgungen (V1, V2) unter der Steuerung der Steuereinheit (302) der Relaisbeobachtungsvorrichtung (300).

9. Relaisbeobachtungsverfahren für eine Schaltsteuervorrichtung (10) mit zwei Stromversorgungen nach Anspruch 8, umfassend:
Beobachten, ob Kontakte von zwei Relais (101, 102) in einer Stromversorgungs-Umwandlungseinheit (100) in der Schaltsteuervorrichtung (10) mit zwei Stromversorgungen schmelzgeschweißt sind, wobei die zwei Relais (101, 102) jeweils zum Verbinden einer Stromversorgung der zwei Stromversorgungen (V1, V2) verwendet werden; und
in dem Fall, dass die Kontakte von mindestens einem Relais (101, 102) schmelzgeschweißt sind, Alarmieren eines Benutzers und Steuern der Stromversorgungs-Umwandlungseinheit (100), um keine Stromversorgung der zwei Stromversorgungen (V1, V2) zu verbinden, und Steuern einer Schaltausführungseinheit (200) in der Schaltsteuervorrichtung (10) mit zwei Stromversorgungen, um das Stromversorgungsschalten einer Hauptleitung nicht auszuführen.

10. Relaisbeobachtungsverfahren nach Anspruch 9, wobei
Bestimmen, dass das Schmelzschweißen in zwei Relais (101, 102) erfolgt, in dem Fall, dass die Hauptleitung auslöst,
Bestimmen, dass das Schmelzschweißen in einem Relais (101, 102) erfolgt, in dem Fall, dass die Hauptleitung nicht auslöst und das Schmelzschweißen durch die Schmelzschweiß-Beobachtungseinheit beobachtet wird.

11. Relaisbeobachtungsverfahren nach Anspruch 9, wobei in dem Fall, dass die Hauptleitung nicht auslöst und das Schmelzschweißen beobachtet wird, Bestimmen, dass das Relais, das schließlich gesteuert wird, um ausgeschaltet zu werden, bevor das Schmelzschweißen beobachtet wird, das Relais ist, in dem das Schmelzschweißen erfolgt.

12. Relaisbeobachtungsverfahren nach Anspruch 11, wobei in dem Fall, dass das Schmelzschweißen beobachtet wird, Steuern, dass das Relais (101, 102), in dem das Schmelzschweißen erfolgt, kontinuierlich ein- und ausgeschaltet wird, bis das Schmelzschweißen nicht mehr beobachtet wird oder das Ein- und Ausschalten für eine vorbestimmte Anzahl von Malen ausgeführt wurde.

13. Relaisbeobachtungsverfahren nach Anspruch 11, wobei
die Art des Alarmierens des Benutzers in Abhängigkeit davon variiert, welches Relais (101, 102) das Relais ist, in dem das Schmelzschweißen erfolgt, oder
die Arten des Alarmierens des Benutzers in Abhängigkeit davon variiert, ob das Schmelzschweißen in einem oder beiden Relais (101, 102) erfolgt.

## Revendications

1. Dispositif de surveillance de relais (300) pour un dispositif de commande de commutation à double alimentation électrique (10), comprenant :
une unité de surveillance de soudure par fusion de relais (301), destinée à surveiller si les contacts de deux relais (101, 102) dans une unité de conversion d'alimentation électrique (100) dans le dispositif de commande de commutation à double alimentation électrique (10) sont soudés par fusion, et les deux relais (101, 102) sont respectivement utilisés pour connecter une alimentation électrique de la double alimentation électrique (V1, V2) ;
une unité de commande pour commander l'unité de conversion d'alimentation électrique (100) afin de connecter une alimentation électrique de la double alimentation électrique (V1, V2) à une unité d'exécution de commutation (200) dans le dispositif de commande de commutation à double alimentation électrique (10) par l'intermédiaire du relais correspondant (101, 102), et pour commander l'unité d'exécution de commutation (200) afin de connecter ladite alimentation électrique à une ligne principale ; et
une unité d'alarme (303) pour alerter un utilisateur dans le cas où les contacts d'au moins un relais sont soudés par fusion, dans lequel
l'unité de commande (302) commande l'unité de conversion d'alimentation électrique (100) pour ne connecter aucune alimentation électrique de la double alimentation électrique (V1, V2) et commande l'unité d'exécution de commutation (200) pour ne pas exécuter la commutation d'alimentation électrique de la ligne principale dans le cas où les contacts d'au moins un relais (101, 102) sont soudés par fusion,
**caractérisé en ce que**
l'unité de surveillance de soudure par fusion de relais (301) est connectée à une borne de connexion commune des deux relais (101, 102), et le fait que les contacts des relais (101, 102) sont soudés par fusion est surveillé en détectant si la tension à la borne de connexion commune dépasse une valeur seuil dans le cas où l'un des deux relais (101, 102) n'est pas commandé de manière conductrice par l'unité de commande (302).

2. Dispositif de surveillance de relais (300) selon la revendication 1, dans lequel
l'unité de surveillance de soudure par fusion de relais (301) comprend une unité de limitation de courant et de redressement (3011) et une unité de détection et de comparaison de tension (3012) ;
l'unité de limitation de courant et de redressement (3011) limite en courant et redresse la tension à la borne de connexion commune des deux relais (101, 102) ; et
l'unité de détection et de comparaison de tension (3012) détecte la tension limitée en courant et redressée et délivre un signal indiquant l'existence d'une soudure par fusion en réponse au fait que la tension détectée dépasse une valeur seuil.

3. Dispositif de surveillance de relais (300) selon la revendication 2, dans lequel
l'unité de détection et de comparaison de tension (3012) comprend une diode Zener (U2), une première résistance (R1), une deuxième résistance (R2), une troisième résistance (R3), un tube de commutation électronique à semi-conducteur (U3) et un dispositif optocoupleur (U1) ;
la cathode de la diode Zener est connectée à l'extrémité de sortie positive de l'unité de limitation de courant et de redressement (3011), l'anode de la diode Zener (U2) est connectée à la première extrémité de la première résistance (R1), la deuxième extrémité de la première résistance (R1) est connectée à la première extrémité de la deuxième résistance (R2), la deuxième extrémité de la deuxième résistance (R2) est connectée à l'extrémité de sortie négative de l'unité de limitation de courant et de redressement (3011), et l'extrémité de commande du tube de commutation électronique à semi-conducteur (U3) est connectée à la première extrémité de la deuxième résistance (R2), la première extrémité du tube de commutation électronique à semi-conducteur (U3) est connectée à l'extrémité de sortie négative de l'unité de limitation de courant et de redressement (3011), la deuxième extrémité du tube de commutation électronique à semi-conducteur (U3) est connectée à la première extrémité du côté entrée du dispositif optocoupleur (U1), la deuxième extrémité du côté entrée du dispositif optocoupleur (U1) est connectée à l'extrémité de sortie positive de l'unité de limitation de courant et de redressement (3011), la première extrémité du côté sortie du dispositif optocoupleur (U1) est utilisée comme extrémité de sortie de signal de surveillance et connectée à une alimentation électrique de référence par l'intermédiaire de la troisième résistance (R3), et la deuxième extrémité du côté sortie du dispositif optocoupleur (U1) est mise à la terre.

4. Dispositif de surveillance de relais (300) selon la revendication 1, dans lequel
l'unité de commande (302) détermine que la soudure par fusion se produit dans deux relais (101, 102) dans le cas où la ligne principale se déclenche,
l'unité de commande (302) détermine que la soudure par fusion se produit dans un relais (101, 102) dans le cas où la ligne principale ne se déclenche pas et où la soudure par fusion est surveillée par l'unité de surveillance de soudure par fusion de relais (301).

5. Dispositif de surveillance de relais (300) selon la revendication 4, dans lequel
l'unité de commande (302) détermine le relais qui est finalement commandé pour être désactivé avant que la soudure par fusion ne soit surveillée comme étant le relais dans lequel la soudure par fusion se produit dans le cas où la ligne principale ne se déclenche pas et où la soudure par fusion est surveillée par l'unité de surveillance de soudure par fusion de relais (301).

6. Dispositif de surveillance de relais (300) selon la revendication 5, dans lequel
dans le cas où la soudure par fusion est surveillée par l'unité de surveillance de soudure par fusion de relais (301), l'unité de commande (302) commande le relais dans lequel la soudure par fusion se produit pour qu'il soit continuellement activé et désactivé jusqu'à ce que la soudure par fusion ne soit plus surveillée ou que l'activation et la désactivation aient été exécutées un nombre prédéterminé de fois.

7. Dispositif de surveillance de relais (300) selon la revendication 5, dans lequel
l'unité d'alarme (303) émet des alarmes de différentes manières pour différents relais dans lesquels la soudure par fusion se produit, ou
l'unité d'alarme (303) émet des alarmes de différentes manières pour la situation où la soudure par fusion se produit dans un relais (101, 102) et la situation où la soudure par fusion se produit dans deux relais (101, 102).

8. Dispositif de commande de commutation à double alimentation électrique (10), comprenant :
un dispositif de surveillance de relais (300) selon l'une quelconque des revendications 1 à 7 ;
une unité d'exécution de commutation (200) pour exécuter la commutation d'alimentation électrique de la ligne principale sous la commande d'une unité de commande (302) du dispositif de surveillance de relais (300) ; et
une unité de conversion d'alimentation électrique (100) pour connecter l'unité d'exécution de commutation (200) à une alimentation électrique de la double alimentation électrique (V1, V2) sous la commande de l'unité de commande (302) du dispositif de surveillance de relais (300).

9. Procédé de surveillance de relais pour un dispositif de commande de commutation à double alimentation électrique (10) selon la revendication 8, consistant à :
surveiller si les contacts de deux relais (101, 102) dans une unité de conversion d'alimentation électrique (100) dans le dispositif de commande de commutation à double alimentation électrique (10) sont soudés par fusion, dans lequel les deux relais (101, 102) sont respectivement utilisés pour connecter une alimentation électrique de la double alimentation électrique (V1, V2) ; et
dans le cas où les contacts d'au moins un relais (101, 102) sont soudés par fusion, alerter un utilisateur et commander l'unité de conversion d'alimentation électrique (100) pour ne connecter aucune alimentation électrique de la double alimentation électrique (V1, V2) et commander une unité d'exécution de commutation (200) dans le dispositif de commande de commutation à double alimentation électrique (10) pour ne pas exécuter la commutation d'alimentation électrique d'une ligne principale.

10. Procédé de surveillance de relais selon la revendication 9, dans lequel il est déterminé que la soudure par fusion se produit dans deux relais (101, 102) dans le cas où la ligne principale se déclenche,
il est déterminé que la soudure par fusion se produit dans un relais (101, 102) dans le cas où la ligne principale ne se déclenche pas et où la soudure par fusion est surveillée par l'unité de surveillance de soudure par fusion.

11. Procédé de surveillance de relais selon la revendication 9, dans lequel
dans le cas où la ligne principale ne se déclenche pas et où la soudure par fusion est surveillée, il est déterminé que le relais qui est finalement commandé pour être désactivé avant que la soudure par fusion ne soit surveillée est le relais dans lequel la soudure par fusion se produit.

12. Procédé de surveillance de relais selon la revendication 11, dans lequel
dans le cas où la soudure par fusion est surveillée, le relais (101, 102) dans lequel la soudure par fusion se produit est commandé pour être continuellement activé et désactivé jusqu'à ce que la soudure par fusion ne soit plus surveillée ou que l'activation et la désactivation aient été exécutées un nombre prédéterminé de fois.

13. Procédé de surveillance de relais selon la revendication 11, dans lequel
la manière d'alerter l'utilisateur varie selon le relais (101, 102) dans lequel se produit la soudure par fusion, ou
la manière d'alerter l'utilisateur varie selon que la soudure par fusion se produit dans un seul ou dans les deux relais (101, 102).
